# EUROPÄISCHE PATENTSCHRIFT

(11) **EP 2 204 075 B1**
(45) Veröffentlichungstag und Bekanntmachung des Hinweises auf die Patenterteilung: **17.08.2011**
(21) Anmeldenummer: 07820345.2
(22) Anmeldetag: 19.09.2007
(51) Int. Cl.: H05B 33/22, H05B 33/12

(54) **FLEXIBLES DÜNNSCHICHT-ELEKTROLUMINESZENZ-LEUCHTELEMENT**
FLEXIBLE THIN-LAYER ELECTROLUMINESCENT LIGHTING ELEMENT
ÉLÉMENT ÉLECTROLUMINESCENT FLEXIBLE EN COUCHE MINCE

(43) Veröffentlichungstag der Anmeldung: 07.07.2010
(73) Patentinhaber: Lightlite GmbH, 3014 Bern (CH)
(72) Erfinder: BONO, Diego, CH-3014 Bern (CH); VON NIEDERHÄUSERN, Erich, CH-3014 Bern (CH)
(74) Vertreter: BOVARD AG
(86) Internationale Anmeldenummer: PCT/EP2007/059901
(87) Internationale Veröffentlichungsnummer: WO 2009/039878

(56) Entgegenhaltungen:
- US-A- 5 856 029
- US-A- 5 976 613
- US-A1- 2002 155 214
- US-A1- 2004 183 434

## Beschreibung

Die Erfindung betrifft ein flexibles Dünnschicht-Elektrolumineszenz-Leuchtelement. Ein solches Element kann zum Beispiel in und auf Kleidungsstücken verwendet werden.

### Stand der Technik

Dünnschicht-Elektrolumineszenz-Leuchtelemente sind bekannt. So ist beispielsweise in Figur 1 von US 6 621 212 B1 eine Struktur dargestellt, die ein Laminat ist, welches eine transparente Elektrodenschicht, eine licht-emittierende Schicht, eine dielektrische Schicht, eine Rückflächen-Elektrodenschicht und eine Sammelschiene zusammenfasst.

In EP 1 084 633 wird auch ein solches Leuchtelement beschrieben, welches zusätzlich einen Träger aus Polyester umfasst. Das Leuchtelement ist in oder auf einem Kleidungsstück angebracht, kann aber auch unabhängig von Kleidungsstücken als leuchtendes Band oder Blache Anwendung finden.

US 5 856 029 A offenbart ein Leuchtelementensystem in dem benachbarte Schichten vor dem Gebrauch in einer unitären Trägerbindung suspendiert worden sind, so dass sich diese Schichten nach dem Aushärten innerhalb einer monolithischen Masse befinden. Bevorzugt als Trägerbindung ist ein Vinylharz in Gelform.

US2002155214 A1 offenbart Verfahren für die Integration von beleuchteten Anzeigen in Artikel aus Gewebe oder Textilien. Beschrieben ist ein Verfahren in dem ein Bild über ein Gewebeteil plaziert wird um eine Anzeigefläche zu definieren, wobei ein Katalysator auf diesen Bereich augetragen wird. Auch beschrieben ist die Möglichkeit, ein Stück Gewebe oder Textilien auf einen rigiden Träger aufzukleben, um eine genauere Plazierung von Schichten zu erleichtern.

US2004183434 offenbart ein Leuchtelement mit zweiseitigen leuchtenden Oberflächen sowie Produktionsverfahren für solche Leuchtelemente. Der Gebrauch von einer gemeinsamen Schicht ist vorgeschlagen, weniger Schichten notwendig sind, und damit das Leuchtelement weniger dick und schwer wird.

Alle bisher vorgeschlagenen Leuchtelemente haben insbesondere den Nachteil, dass sie entweder rigid oder nicht Falt- und Knickresistent sind.

### Offenbarung der Erfindung

Aufgabe der vorliegenden Erfindung ist die Bereitstellung eines flexiblen Dünnschicht-Elektrolumineszenz-Leuchtelementes, welches die Konsistenz und Anwendungskonformität eines textilen Stoffes erreicht.

Erfindungsgemäss wir diese Aufgabe durch ein flexibles Dünnschicht-Elektrolumineszenz-Leuchtelement gelöst, das die nachstehenden Bestandteile umfasst:
- eine isolierende transparente Schicht, die als Trägermaterial dient;
- eine transparente Elektrodenschicht, die auf der Oberfläche der isolierenden transparenten Schicht vorgesehen ist;
- eine licht-emittierende Schicht, die auf der transparenten Elektrodenschicht vorgesehen ist;
- eine dielektrische Schicht, die auf der licht-emittierenden Schicht vorgesehen ist;
- eine Rückflächen-Elektrodenschicht, die auf der dielektrischen Schicht vorgesehen ist; und
- eine isolierende Überzugschicht, die auf der Rückflächen-Elektrodenschicht vorgesehen ist;
   und das sich dadurch kennzeichnet, dass die isolierende transparente als Träger dienende Schicht ein Gewebe aus Polyvinyliden Fluorid (PVDF) enthält.
   Gemäss einer weiterer Ausführungsform der Erfindung ist das oben genannte erfindungsgemässe Leuchtelement so geändert, dass
- die isolierende Überzugschicht durch eine zusätzliche dielektrische Schicht ersetzt ist;
- eine zusätzliche licht-emittierende Schicht auf der zusätzlichen dielektrischen Schicht vorgesehen ist;
- eine zusätzliche transparente Elektrodenschicht auf der zusätzlichen licht-emittierenden Schicht vorgesehen ist; und
- eine zusätzliche isolierende transparente als Trägermaterial dienende Schicht auf der zusätzlichen transparenten Elektrodenschicht vorgesehen ist und ein Gewebe aus Polyvinyliden Fluorid (PVDF) enthält.

Weitere Merkmale und Zweckmässigkeiten der Erfindung ergeben sich aus der folgenden Beschreibung anhand von Figuren. Von den Figuren zeigen schematisch:
Figur 1 : eine Querschnittansicht des erfindungsgemässen Leuchtelements;
Figur 2 : eine Querschnittansicht einer bevorzugten Ausführungsform des erfindungsgemässen Leuchtelements; und
Figur 3 : eine weitere Ausführungsform des erfindungsgemässen Leuchtelements.

### Ausführliche Beschreibung der Erfindung

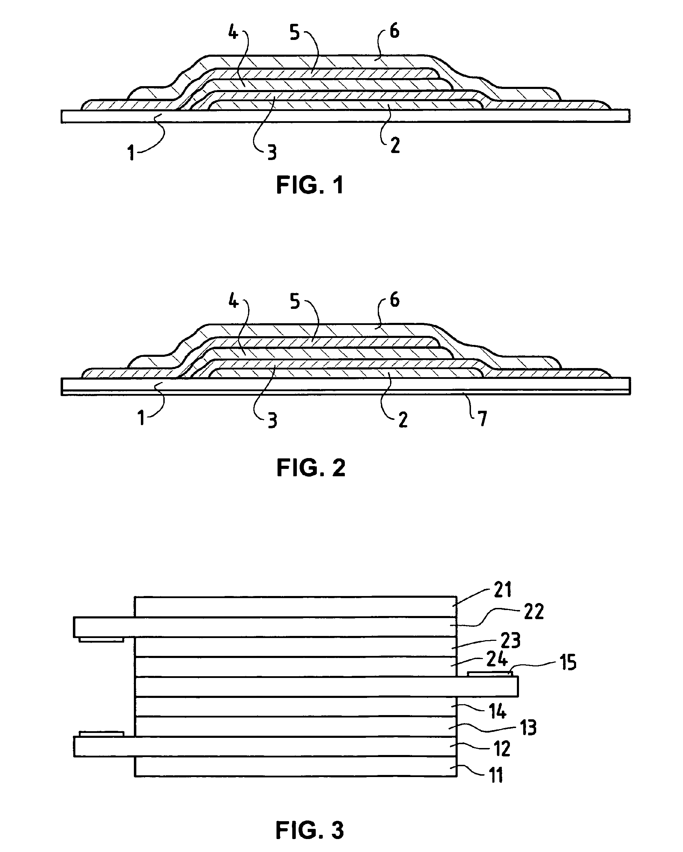

Das erfindungsgemässe flexible Dünnschicht-Elektrolumineszenz-Leuchtelement wird in Fig. 1 dargestellt.

Eine transparente isolierende als Träger dienende Schicht 1 enthält ein Gewebe aus Polyvinyliden Fluorid. Dieses Gewebe muss erfindungsgemäss flexibel sein. Dank diesem Merkmal kann die Schicht 1 seine Funktion als Träger erfüllen, ohne dem ganzen Leuchtelement Starre oder Steifheit zu geben. Damit ist es möglich, Leuchtelemente in jeder geometrischen Form zu erzeugen, die eine grosse Flexibilität aufweisen.

Vorzugsweise wird ein Gewebe eingesetzt, dessen Fäden mit einer Polymer Mischung beschichtet sind. Diese Polymer Mischung ist bevorzugt eine Fluorpolymer Mischung, insbesondere eine 100% Fluorpolymer Mischung.

Leuchtelemente mit guten Flexibilitätseigenschaften werden mit einem Gewebe erhalten, dessen gewebetechnische Spezifikationen wie folgt lauten :
- Material: PVDF (Polyvinyliden Fluorid)
- Fädenbeschichtung : 100% Fluopolymer Mischung
- Bindung : Leinwand 1/1
- Flächengewicht : 220 g/m²
- Höchstzugkraft Kette/Schuss (N/ 5cm) : 1050/1050 anch DIN 53354
- Höchstzugkraftdehnung Kette/Schuss (%) : 40/25 nach DIN 53354
- Weiterreisskraft Kette/Schuss (N) : 35/50 nach DIN 53859-5
- Wassersäule / Dichtigkeit (mm)= : grösser als 500 mm WS
- Brandverhalten: B1 nach DIN 4102; B-s1, d= nach DIN EN 1 3501-1
- Fadendichte (Anzahl Kett- und Schussfäden pro Längeneinheit) : kann je nach Anwendung festgelegt werden
- Bindungsart : dito

Die lichttechnische Spezifikationen dieses Gewebes sind die Folgenden :
- Transmissionsgrad : 80%
- Reflexionsgrad : 19%
- Absorptionsgrad : 1 %

Gewebe mit besseren Eigenschaften können auch zur Anwendung kommen.

Vorzugsweise wird die Flexibilität, bzw. die Verformbarkeit oder Biegbarkeit des Gewebes je nach Anwendung maximal optimiert. Die Biegeresp. Faltradien betragen in jedem Fall < 5 mm und > 0,1mm.

Die transparente Elektrodenschicht 2, die auf der Oberfläche der isolierenden transparenten Schicht 1 liegt, besteht aus einem dem Fachmann bekannten geeigneten Material, zum Beispiel ITO (Indium und Zinn Oxid), Aluminium, Silber, ein Leiterpolymer, usw. Die Dicke dieser Elektrodenschicht beträgt im Allgemeinen zwischen 15 und 40 µm, vorzugsweise zwischen 20 und 22 µm.

Die lichtemittierende Schicht 3, die auf der transparenten Elektrodenschicht 2 liegt, besteht aus einem herkömmlichen geeigneten Material, zum Beispiel, ein phophoreszierendes Licht emittierendes Material, nämlich ein Zinn-Sulphid haltiges Material, gegebenenfalls mit einem Dotierungsstoff, um die Farbe des Lichts zu ändern.

Die Dicke dieser licht-emittierenden Schicht beträgt im Allgemeinen zwischen 30 und 60 µm, vorzugsweise zwischen 45 und 50 µm.

Die dielektrische Schicht 4, die auf der licht-emittierenden Schicht 3 liegt, besteht üblicherweise aus einem geeigneten dielektrischen Pulver, z.B. Polypropylen, Polyethylen, Polyethylen Terephatlat (PET), polycarbonate, polysulfone und polystyrene. Mischungen von Titanium Dioxid, Silicon Dioxid und Aluminium Silikat können auch zum Einsatz kommen.

Die Dicke dieser dielektrischen Schicht beträgt im Allgemeinen zwischen 5 und 20 µm, vorzugsweise zwischen 10 und 15 µm.

Die Rückflächen-Elektrodenschicht 5, die auf der dielektrischen Schicht 4 liegt, besteht üblicherweise aus einer geeigneten herkömmlichen leitfähigen Tinte oder aus Silber, Kohlenstoff, Keramik oder Mischungen von Kohlenstoff-Silber oder Nickel-Silber in einem geeigneten Bindemittel wie ein Fluorpolymer, insbesondere Polyvinyliden Fluorid.

Die Dicke dieser dielektrischen Schicht beträgt im Allgemeinen zwischen 5 und 30 µm, vorzugsweise ungefähr 10 µm.

Die isolierende Überzugschicht 6, die auf der Rückflächen-Elektrodenschicht 5 liegt, besteht aus einem herkömmlichen geeigneten Material, wie Teflon®, Polypropylen, PVC oder ähnliche Materialien.

Die Dicke dieser isolierenden Überzugschicht kann je nach Anwendungsbereich stark variieren und kann zwischen 10 µm und 0,5 mm betragen.

Vorteilhafterweise, wie in Fig. 2 dargestellt, weist das Gewebe 7 auf seiner äusseren Seite eine undurchlässige transparente Schicht 7 auf, die wiederum aus einem herkömmlichen geeigneten Material, wie Teflon®, Polypropylen, PVC oder ähnliche Materialien besteht. Die Schicht dient nämlich zur Verstärkung der Wasserdichtigkeit, der Spannungsfestigkeit , der Dampf- und Feuchtigkeitsresistenz.

Die Dicke dieser undurchlässigen transparenten Schicht kann je nach Anwendungsbereich stark variieren und kann zwischen 10 µm und 0,5 mm betragen.

Das in Fig.1 oder 2 dargestellte erfindungsgemässe flexible Dünnschicht-Elektrolumineszenz-Leuchtelement kann dank seiner hohen Flexibilität in jeder geometrischen Form angewendet werden. Beim Einsatz in Kleidungsstücken sind diese somit komfortabel zu tragen im Gegensatz zu dem in EP 1 084 633 beschriebenen Kleidungsstück.

Eine weitere Ausführungsform der Erfindung ist in Figur 3 dargestellt. In dieser Ausführungsform befindet sich ein zusätzliche dielektrische Schicht 24 anstelle der isolierenden Überzugschicht. Dieses Leuchtelement weist zudem
- auf der zusätzlichen dielektrischen Schicht 24 eine zusätzliche licht-emittierende Schicht 23;
- auf der zusätzlichen licht-emittierenden Schicht 23 eine zusätzliche transparente Elektrodenschicht 22; und
- auf der zusätzlichen transparenten Elektrodenschicht 22 eine zusätzliche isolierende transparente als Trägermaterial dienende Schicht 21 auf.

Die Schichten 24, 23, 22 und 21 sind ähnlich wie die Schichten 14,13,12 und 11, die den Schichten 4, 3, 2 und 1 des in Fig. 1 dargestellten Leuchtelements entsprechen. Die Schicht 15 entspricht der Schicht 5 der Figur 1.

Ähnlich wie bei der Schicht (1) der Figur 2 ist vorzugsweise eine undurchlässige (nicht dargestellt) Schicht auf der zusätzlichen isolierenden transparenten Schicht 21 vorgesehen.

Das Leuchtelement der Figur 3 hat den Vorteil, dass es beidseitig leuchten kann.

Zur Herstellung des erfindungsgemässen flexiblen Dünnschicht-Elektrolumineszenz-Leuchtelements kann irgendein geeignetes Verfahren verwendet werden. Der Fachmann kann sich auf das zitierte Dokument US 6 621 212 oder auf US 5 976 613 beziehen. In diesen Dokumenten kann der Fachmann auch weitere Informationen betreffend den Zusammensetzungen der verschiedenen Schichten finden.

Die Anwendung in einem Kleidungsstück (mit den zugeordneten elektronischen Bestandteilen) kann wie in EP 1 084 633 beschrieben in die Praxis umgesetzt werden.

## Patentansprüche

1. Flexibles Dünnschicht-Elektrolumineszenz-Leuchtelement, das die nachstehenden Bestandteile umfasst:
- eine isolierende transparente Schicht (1), die als Trägermaterial dient;
- eine transparente Elektrodenschicht (2), die auf der Oberfläche der isolierenden transparenten Schicht (1) vorgesehen ist;
- eine licht-emittierende Schicht (3), die auf der transparenten Elektrodenschicht (2) vorgesehen ist;
- eine dielektrische Schicht (4), die auf der licht-emittierenden Schicht (3) vorgesehen ist;
- eine Rückflächen-Elektrodenschicht (5), die auf der dielektrischen Schicht (4) vorgesehen ist; und
- eine isolierende Überzugschicht (6), die auf der Rückflächen-Elektrodenschicht (5) vorgesehen ist;
**dadurch gekennzeichnet, dass** die isolierende transparente Schicht (1) ein Gewebe aus Polyvinyliden Fluorid enthält.

2. Flexibles Dünnschicht-Elektrolumineszenz-Leuchtelement nach Anspruch 1, wobei die isolierende transparente Schicht (1) aus einem Gewebe besteht.

3. Flexibles Dünnschicht-Elektrolumineszenz-Leuchtelement nach Anspruch 1 oder 2, wobei die Biege- resp. Faltradien des Gewebes zwischen 0,1 und 5 mm liegen.

4. Flexibles Dünnschicht-Elektrolumineszenz-Leuchtelement nach Anspruch 3, wobei die Fäden des Gewebes mit einer Fluoropolymer Mischung beschichtet sind.

5. Flexibles Dünnschicht-Elektrolumineszenz-Leuchtelement nach einem der Ansprüche 1 bis 4, wobei eine dampf- und flüssigkeitsundurchlässige transparente Schicht (7) auf der äusseren Seite des Gewebes vorgesehen ist.

6. Flexibles Dünnschicht-Elektrolumineszenz-Leuchtelement nach einem der Ansprüche 1 bis 5, wobei
- die isolierende Überzugschicht (6) durch eine zusätzliche dielektrische Schicht (24) ersetzt ist;
- eine zusätzliche licht-emittierende Schicht (23) auf der zusätzlichen dielektrischen Schicht (24) vorgesehen ist;
- eine zusätzliche transparente Elektrodenschicht (22) auf der zusätzlichen licht-emittierenden Schicht (23) vorgesehen ist; und
- eine zusätzliche isolierende transparente als Trägermaterial dienende Schicht (21) auf der zusätzlichen transparente Elektrodenschicht (22) vorgesehen ist und ein Gewebe aus Polyvinyliden Fluorid enthält.

7. Flexibles Dünnschicht-Elektrolumineszenz-Leuchtelement nach Anspruch 6, wobei die Biege- resp. Faltradien des Gewebes zwischen 0,1 und 5 mm liegen.

8. Flexibles Dünnschicht-Elektrolumineszenz-Leuchtelement nach Anspruch 1, wobei die Fäden des Gewebes mit einer Fluoropolymer Mischung beschichtet sind.

9. Flexibles Dünnschicht-Elektrolumineszenz-Leuchtelement nach einem der Ansprüche 6 bis 8, wobei eine undurchlässige transparente Schicht auf der zusätzlichen isolierenden transparenten Schicht (21) vorgesehen ist.

## Claims

1. Flexible thin-layer electroluminescent lighting element comprising the following components:
- an insulating transparent layer (1) serving as a carrier material;
- a transparent electrode layer (2) provided on the surface of the insulating transparent layer (1);
- a light-emitting layer (3) provided on the transparent electrode layer (2);
- a dielectric layer (4) provided on the light-emitting layer (3);
- a rear electrode layer (5) provided on the dielectric layer (4); and
- an insulating coating layer (6) provided on the rear electrode layer (5);
**characterised in that** the insulating transparent layer (1) contains a woven material of polyvinylidene fluoride.

2. Flexible thin-layer electroluminescent lighting element according to claim 1, the insulating transparent layer (1) consisting of a woven material.

3. Flexible thin-layer electroluminescent lighting element according to claim 1 or 2, the bending or respectively folding radii of the woven material being between 0.1 and 5 mm.

4. Flexible thin-layer electroluminescent lighting element according to claim 3, the threads of the woven material being coated with a fluoropolymer mixture.

5. Flexible thin-layer electroluminescent lighting element according to one of the claims 1 to 4, a transparent layer (7) impervious to water vapour and liquids being provided on the outer side of the woven material.

6. Flexible thin-layer electroluminescent lighting element according to one of the claims 1 to 5, whereby
- the insulating coating layer (6) is replaced by an additional dielectric layer (24);
- an additional light-emitting layer (23) is provided on the additional dielectric layer (24);
- an additional transparent electrode layer (22) is provided on the additional light-emitting layer (23); and
- an additional insulating transparent layer (21) serving as a carrier material is provided on the additional transparent electrode layer (22) and contains a woven material of polyvinylidene fluoride.

7. Flexible thin-layer electroluminescent lighting element according to claim 6, the bending or respectively folding radii of the woven material being between 0.1 and 5 mm.

8. Flexible thin-layer electroluminescent lighting element according to claim 1, the threads of the woven material being coated with a fluoropolymer mixture.

9. Flexible thin-layer electroluminescent lighting element according to one of the claims 6 to 8, an impervious transparent layer being provided on the additional insulating transparent layer (21).

## Revendications

1. Elément d'éclairage électroluminescent flexible en couche mince comprenant les composants suivants:
- une couche isolante transparente (1) servant de matériau porteur;
- une couche transparente d'électrode (2) prévue sur la surface de la couche isolante transparente (1);
- une couche émettrice de lumière (3) prévue sur la couche transparente d'électrode (2);
- une couche diélectrique (4) prévue sur la couche émettrice de lumière (3);
- une couche arrière d'électrode (5) prévue sur la couche diélectrique (4); et
- une couche isolante de revêtement (6) prévue sur la couche arrière d'électrode (5);
**caractérisé en ce que** ladite couche isolante transparente (1) comporte un tissu de polyfluorure de vinylidène.

2. Elément d'éclairage électroluminescent flexible en couche mince selon la revendication 1, dans lequel ladite couche isolante transparente (1) consiste en un tissu.

3. Elément d'éclairage électroluminescent flexible en couche mince selon la revendication 1 ou 2, dans lequel les rayons de courbure ou de pliage dudit tissu ont des valeurs entre 0.1 et 5 mm.

4. Elément d'éclairage électroluminescent flexible en couche mince selon la revendication 3, dans lequel les fils dudit tissu sont recouverts d'un mélange fluoropolymère.

5. Elément d'éclairage électroluminescent flexible en couche mince selon l'une des revendications 1 à 4, dans lequel une couche transparente (7) imperméable à la vapeur d'eau et aux liquides est prévue sur le côté extérieur dudit tissu.

6. Elément d'éclairage électroluminescent flexible en couche mince selon l'une des revendications 1 à 5, dans lequel
- la couche isolante de revêtement (6) est remplacée par une couche diélectrique supplémentaire (24);
- une couche émettrice de lumière supplémentaire (23) est prévue sur ladite couche diélectrique supplémentaire (24);
- une couche transparente d'électrode supplémentaire (22) est prévue sur ladite couche émettrice de lumière supplémentaire (23); et
- une couche isolante transparente supplémentaire (21) servant de matériau porteur est prévue sur ladite couche transparente d'électrode supplémentaire (22) et comporte un tissu de polyfluorure de vinylidène.

7. Elément d'éclairage électroluminescent flexible en couche mince selon la revendication 6, dans lequel les rayons de courbure ou de pliage dudit tissu ont des valeurs entre 0.1 et 5 mm.

8. Elément d'éclairage électroluminescent flexible en couche mince selon la revendication 1, dans lequel les fils dudit tissu sont recouverts d'un mélange fluoropolymère.

9. Elément d'éclairage électroluminescent flexible en couche mince selon l'une des revendications 6 à 8, dans lequel une couche transparente imperméable est prévue sur ladite couche isolante transparente supplémentaire (21).
